# EUROPÄISCHE PATENTSCHRIFT

(11) **EP 0 340 865 B1**
(45) Veröffentlichungstag und Bekanntmachung des Hinweises auf die Patenterteilung: **11.01.1995**
(21) Anmeldenummer: 89201115.6
(22) Anmeldetag: 01.05.1989
(51) Int. Cl.: H01L 39/24, C04B 35/00, C04B 41/49, B05D 5/12, H01B 12/00

(54) **Verfahren zur Herstellung einer supraleitenden Ca-Sr-Bi-Cu-O Schicht**
Method for producing a superconductive Ca-Sr-Bi-Cu-O layer
Procédé pour la production d'une couche supraconductive Ca-Sr-Bi-Cu-O

(30) Priorität: 06.05.1988 DE 3815460
(43) Veröffentlichungstag der Anmeldung: 08.11.1989
(73) Patentinhaber: Philips Electronics N.V., 5621 BA Eindhoven (NL)
(72) Erfinder: Klee, Mareike Katharine, Dr., D-5142 Hückelhoven-Brachelen (DE); Stotz, Siegfried, Dr., D-5100 Aachen (DE)
(74) Vertreter: Volmer, Georg, Dipl.-Ing.

(56) Entgegenhaltungen:
- EP-A- 0 312 284
- JAPANESE JOURNAL OF APPLIED PHYSICS band 27, nr. 2, Teil 2, Februar 1988, Seiten 209, 210, New York, US; H. MAEDA et al.: "A New High-Tc Oxide Superconductor without a Rare Earth Element"
- APPLIED PHYSICS LETTERS Band 51, Nr. 25, 21 Dezember 1987, Seiten 2152-2154, New York, NY, US; A.H. HAMDI et al.: "Formation of thin-film high Tc superconductors by metalorganic deposition"
- PHYSICA C Band 156, Nr. 4, 1 November 1988, Seiten 641-648, Amsterdam, NL; M. KLEE et al.: "Superconductivity above 100 K in Bi(Pb)-Ca-Sr-Cu-O films made by thermal decomposition of metal carboxylates"

## Beschreibung

Die Erfindung betrifft ein Verfahren zur Herstellung einer supraleitenden Ca-Sr-Bi-Cu-O Schicht auf einem Substrat.

Ein derartiges Verfahren ist aus der Arbeit von J.H. Kang et.al in Physics Letters A 128 (1-2), Seiten 102 - 104 (1988) bekannt. Bei diesem Verfahren wird die Schicht durch ein Magnetron-Sputterverfahren hergestellt und dann in Sauerstoff bei 880 bis 900°C thermisch nachbehandelt. Die hergestellte Schicht mit einer Dicke von 1 µm ist supraleitend mit einer kritischen Temperatur Tₖ von etwa 78 K.

Aus Messungen an Formkörpern ist bekannt, daß Wismut-Kuprat-Verbindungen mehrphasig sein können, wobei die unterschiedlichen Phasen verschiedene kritische Temperaturen aufweisen, zum Beispiel 80 K und 105 K, siehe H. Maeda et al. in Japanese Journal of Applied Physics Letters 27 (2), L209 (1988). Das oben angedeutete Dünnschichtverfahren liefert aber ein Material mit einer Widerstands-Temperatur-Kurve, die fast keinen Anteil an der Phase aufweist, die die höhere kritische Temperatur hat, d.h. oberhalb von 100 K. Versuche, die zu der Erfindung geführt haben, zeigen außerdem, daß auch ein Laserabscheideverfahren und eine thermische Nachbehandlung dieser dünnen Schichten diese Sachlage nicht verbessern.

Aus dem Aufsatz von A.H. Hamdi, et al., in Application Physics Letters 51, 21.12.1987, Seiten 2152-2154 ist ein ähnliches Verfahren bekannt, bei dem allerdings keine Wismut-Kuprat-Verbindung eingesetzt wird. Es handelt sich dabei um ein Verfahren zur Herstellung von Y₁Ba₂Cu₃Oₓ Schichten in einem naßchemischen Verfahren unter Verwendung von Neodekanoaten als Rohstoffen. Nach der Beschichtung von den Substraten mit einer dieser Rohstoffe enthaltenden Lösung und Zwischenbehandlungen bei 500°C erfolgt eine Nachbehandlung bei 850°C und ein anschließendes langsames Abkühlen auf Raumtemperatur. Mit diesem Verfahren werden supraleitende Schichten mit einem jedoch sehr breiten Übergang erzeugt, welche erst bei Temperaturen von 37 K vollständig supraleitend sind.

Eine Aufgabe der Erfindung ist es, ein Verfahren zur Herstellung der eingangs erwähnten Schicht zu schaffen, bei dem die Prozeßparameter, wie Stoechiometrie, Temperaturführung usw., genau gesteuert werden können.

Dabei wird beabsichtigt, Schichten mit einem wirkungsvollen Anteil an einer Phase mit einer kritischen Temperatur oberhalb von 100 K herzustellen.

Eine weitere Aufgabe der Erfindung ist es, ein Verfahren zu schaffen, mit dem auf einfache und billige Weise auch Schichten bzw. Beschichtungen hergestellt werden können, die eine größere Dicke, zum Beispiel größer als 10 µm, haben.

Diese Aufgaben werden erfindungsgemäß dadurch gelöst, daß eine homogene Lösung von Calciumnaphthenat, Strontiumoktoat, Wismutoktoat und Kupfer-2-ethylhexanoat, oder eine homogene Lösung von Calciumnaphthenat, Strontium-cylcohexanbutyrat, Wismut-tri-phenyl und Kupfer-2-ethylhexanoat in Kohlenwasserstoffen hergestellt werden, wonach diese Lösung mit einem organischen Lösungsmittel, wie Chloroform versetzt wird,
wonach diese Lösung auf dem Substrat abgeschieden wird, wonach die metallorganischen Verbindungen thermisch zersetzt werden,
wobei der Vorgang gegebenenfalls so oft wiederholt wird, bis die vorbestimmte Schichtdicke erreicht worden ist, wonach die Schicht auf eine Temperatur zwischen 700 und 950°C aufgeheizt wird und bei dieser Temperatur an Luft konsolidiert wird,
wonach die Schicht mit 210 K/h auf 650°C abgekühlt wird und bei dieser Temperatur nachbehandelt wird, wonach die Schicht auf Raumtemperatur abgekühlt wird.

Besondere Ausgestaltungen der Erfindung ergeben sich aus den Unteransprüchen.

Die Lösung enthält insbesondere Verbindungen, bei welchen die relevanten Metallatome chemisch mit organischen Molekülen verbunden sind. Im weiteren werden solche Verbindungen als metallorganisch bezeichnet.

Zum Abscheiden der homogenen Lösung auf dem Substrat können sämtliche an sich bekannte Verfahren angewendet werden, wie zum Beispiel Schleudern, Tauchen und Sprühen.

Die metallorganischen Verbindungen werden vorzugsweise bei einer Temperatur von 300 bis 600°C zersetzt.

Geeignete Substratmaterialien sind zum Beispiel MgO (keramisch oder einkristallin), SrTiO₃, Al₂0₃ und Zr0₂.

Gegebenenfalls kann das gesamte Verfahren, inklusive der Umsetzung bei 700 bis 950°C, mehrmals ausgeführt werden.

Bei dem Verfahren nach der Erfindung werden bei der thermischen Zersetzung Oxide und teilweise Carbonate (Sr, Ca) gebildet. Bei dem Laserabscheideverfahren und anderen Vakuumverfahren müssen die Schichten einer Hochtemperaturbehandlung (ungefähr 900°C) unterzogen werden, damit die gewünschten Oxide gebildet werden, wobei zuerst die Phase mit dem niederigem Wert von Tₖ entsteht. Die Reaktionsneigung in dem Material ist dann zu gering, um bei anschließender thermischer Behandlung einen bedeutenden Anteil des Materials in die Phase mit dem hohen Wert von Tₖ umzuwandeln.

Von T. Kumagai et al. ist in Chemistry Letters, Seiten 1645-1646 (1987) ein Verfahren beschrieben worden, bei welchem durch Eintauchen in eine organische Lösung und nachfolgende thermische Zersetzung Schichten aus YBa₂Cu₃0_{7-ε}, mit δ von 0 bis 0,5, gebildet werden. Von M.E. Gross et al. ist in Applied Physics Letters 52 (2), Seiten 160 - 162 (1988) ein ähnliches Verfahren beschrieben worden, bei dem die Lösung durch Schleudern auf das Substrat aufgebracht wird. Das supraleitende YBa₂Cu₃0_{7-ε} ist aber kein mehrphasiges Material. Die technische Anwendung der hier angedeuteten Verfahren ist deshalb nicht naheliegend, weil diese im Gegensatz zu Sputterverfahren und anderen vakuumtechnischen Verfahren wie Verdampfen und Spritzen zu porösen Schichten führen, zum Nachteil der erreichbaren kritischen Stromdichte. Bei dem erfindungsgemäßen Verfahren kann man diesen Nachteil in Kauf nehmen, indem durch bessere Steuerung des Verfahrens ereicht wird, daß ein größerer Anteil der Phase mit der höheren kritischen Temperatur gebildet wird.

Vorteile der Wismut-Kuprat-Verbindung gegenüber YBa₂Cu₃0_{7-δ} sind ein höherer Wert von Tₖ und eine größere Stabilität gegenüber Luftfeuchtigkeit.

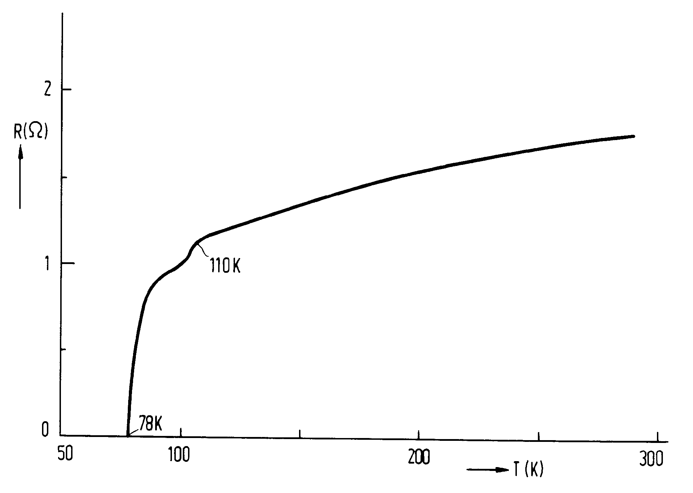

Die Erfindung wird anhand von Ausführungsbeispielen und einer Zeichnung erläutert. In der Zeichnung zeigt die einzige Figur ein Diagramm, in dem der elektrische Widerstand R als Funktion der absoluten Temperatur T dargestellt ist, gemessen an einer nach dem erfindungsgemäßen Verfahren hergestellten Schicht.

### Ausführungsbeispiel 1

Calciumnaphthenat, Strontiumoktoat, Wismutoktoat und Kupfer-2-ethylhexanoat werden in Lösungen in Kohlenwasserstoffen mit einem Siedepunkt von 160 bis 190°C ("white spirit") verwendet, wobei der Gewichtsanteil der Metalle in den Lösungen für Ca 10, für Sr 8, für Bi 20 und für Cu 11,5 % beträgt. Diese Verbindungen werden im molaren Verhältnis Ca:Sr:Bi:Cu = 1:1:1:2 in Chloroform mit einer Kupferkonzentration von 0,5 bis 1 mol/l gelöst. Diese Lösung wird durch Schleudern (800 bis 1000 Umdrehungen pro Minute) auf MgO-Substraten abgeschieden. Die Schicht wird bei 120 bis 150°C innerhalb von 30 Minuten getrocknet. Die metallorganischen Verbindungen werden anschließend bei 500°C ungefähr eine Stunde thermisch zersetzt.

Nach mehrmaligem Beschichten, wobei eine Schichtdicke von 6 µm erreicht wird, erfolgt eine Umsetzung bei 860°C. Dazu werden die Schichten mit 430 K/h auf 860°C aufgeheizt, eine Stunde an Luft konsolidiert, mit 210 K/h auf 650°C abgekühlt und bei dieser Temperatur eine Stunde nachbehandelt. Anschließend werden die Schichten abgeschreckt, d.h. innerhalb von 5 Minuten auf Raumtemperatur abgekühlt.

In der Figur ist der elektrische Widerstand als Funktion der absoluten Temperatur dargestellt. Die Schicht zeigt ein Einsetzen der Supraleitung bei 110 K und ist vollständig supraleitend bei 78 K. Die Zusammensetzung der Schicht ist mehrphasig, wobei ein bedeutender Anteil der Phase mit dem hohen Wert von Tₖ gebildet wurde.

Die Schichten weisen eine polykristalline Textur auf, wobei die Kristallite teilweise mit der c-Achse senkrecht zum Substrat aufgewachsen sind.

### Ausführungsbeispiel 2

Es wird ein Verfahren wie im Beispiel 1 ausgeführt, mit dem Unterschied, daß die Lösung durch Tauchen (1 bis 3 mm/s) auf dem Substrat abgeschieden wird. Die folgende Umsetzung erfolgt bei 880°C. Die Gesamtschichtdicke beträgt 13 µm.

Der Verlauf des elektrischen Widerstands als Funktion der Temperatur ist derselbe wie im vorigen Ausführungsbeispiel. Die kritische Stromdichte bei 73 K beträgt in dieser Schicht mehr als 100 A/cm². Diese Zahl ist für die gesamte Schicht, einschließlich der Poren, angegeben.

### Ausführungsbeispiel 3

Es wird ein Verfahren wie im Beispiel 1 ausgeführt, mit dem Unterschied, daß als metallorganische Verbindungen Calciumnaphthenat, Strontiumcyclohexanbutyrat, Wismuttriphenyl und Kupfer-2-ethylhexanoat verwendet werden. Das Resultat ist dasselbe wie im Ausführungsbeispiel 2, mit einem etwas kleineren Anteil der Phase mit dem höheren Wert von Tₖ.

### Ausführungsbeispiel 4

Es wird ein Verfahren wie im Beispiel 1 ausgeführt, wobei die metallorganischen Verbindungen im Verhältnis Ca:Sr:Bi:Cu = 1.3 : 1.7 : 2 : 3 verwendet werden. Das Resultat ist dasselbe wie im Ausführungsbeispiel 1, mit einem etwas größeren Anteil der Phase mit dem höheren Wert von Tₖ.

### Ausführungsbeispiel 5

Es wird ein Verfahren wie im Beispiel 1 ausgeführt, wobei die metallorganischen Verbindungen im Verhältnis Ca:Sr:Bi:Cu = 1:2:2:2 verwendet werden. Das Resultat ist dasselbe wie im vorigen Ausführungsbeispiel.

### Ausführungsbeispiel 6

Es wird ein Verfahren wie im Beispiel 1 ausgefüht, mit dem Unterschied, daß die Beschichtung und die Umsetzung bei 860°C zweimal durchgeführt werden. Die Gesamtschichtdicke beträgt 13 µm. Durch eine wiederholte Sinterung bei hoher Temperatur wird eine Schicht mit geringerer Porosität erhalten.

## Patentansprüche

1. Verfahren zur Herstellung einer supraleitenden Ca-Sr-Bi-Cu-O Schicht auf einem Substrat,
dadurch gekennzeichnet,
daß eine homogene Lösung von Calciumnaphthenat, Strontiumoktoat, Wismutoktoat und Kupfer-2-ethylhexanoat, oder eine homogene Lösung von Calciumnaphthenat, Strontium-cylcohexanbutyrat, Wismut-tri-phenyl und Kupfer-2-ethylhexanoat in Kohlenwasserstoffen hergestellt werden, wonach diese Lösung mit einem organischen Lösungsmittel, wie Chloroform versetzt wird,
wonach diese Lösung auf dem Substrat abgeschieden wird, wonach die metallorganischen Verbindungen thermisch zersetzt werden,
wobei der Vorgang gegebenenfalls so oft wiederholt wird, bis die vorbestimmte Schichtdicke erreicht worden ist, wonach die Schicht auf eine Temperatur zwischen 700 und 950°C aufgeheizt wird und bei dieser Temperatur an Luft konsolidiert wird,
wonach die Schicht mit 210 K/h auf 650°C abgekühlt wird und bei dieser Temperatur nachbehandelt wird, wonach die Schicht auf Raumtemperatur abgekühlt wird.

2. Verfahren nach Anspruch 1,
dadurch gekennzeichnet, daß die metallorganischen Verbindungen zersetzt werden innerhalb ungefähr einer Stunde bei einer Temperatur von 300-600°C.

3. Verfahren nach Anspruch 1 oder 2,
dadurch gekennzeichnet, daß die Schicht bei einer Temperatur von 650°C ca. eine Stunde nachbehandelt wird.

## Claims

1. A method of manufacturing a superconductive Ca-Sr-Bi-Cu-O layer on a substrate, characterized in that a homogeneous solution of calcium naphtenate, strontium octoate, bismuth octoate and copper-2-ethyl hexanoate or a homogeneous solution of calcium naphtenate, strontium cyclohexane butyrate, bismuth triphenyl and copper-2-ethyl hexanoate in hydrocarbons is manufactured, whereafter an organic solvent, such as chloroform, is added to this solution, and the solution is deposited on the substrate, after which the metalorganic compounds are thermally decomposed, this process being repeated until the predetermined layer thickness is attained, whereafter the layer is heated to a temperature in the range between 700°C and 950°C and consolidated at this temperature in air, after which the layer is cooled to 650°C at a rate of 210 K/h and subjected to (a) post-treatment(s) at this temperature, whereafter the layer is cooled to room temperature.

2. A method as claimed in claim 1, characterized in that the metalorganic compounds are decomposed within approximately one hour at a temperature of from 300 to 600°C.

3. A method as claimed in claim 1 or 2, characterized in that the layer is subjected to a post-treatment at 650°C for approximately one hour.

## Revendications

1. Procédé de fabrication d'une couche supraconductrice Ca-Sr-Bi-Cu-O sur un substrat, caractérisé en ce que l'on prépare dans des hydrocarbures une solution homogène constituée de naphténate de calcium, d'octoate de strontium, d'octoate de bismuth et de 2-éthylhexanoate de cuivre, ou une solution homogène constituée de naphthénate de calcium, de cyclohexanebutyrate de strontium, de tri-phényle de bismuth et de 2-éthylhexanoate de cuivre, après quoi cette solution est mélangée avec un solvant organique, tel que le chloroforme,
après quoi ladite solution est déposée sur le substrat,
après quoi les composés organométalliques sont décomposés thermiquement,
après quoi, le cas échéant, le procédé est répété autant de fois jusqu'à ce que l'épaisseur de couche prédéterminée soit atteinte,
après quoi la couche est chauffée jusqu'à une température comprise entre 700 et 950°C pour être consolidée à l'air à cette température,
après quoi la couche est refroidie à une vitesse de 210 K/h jusqu'à 650°C pour subir un traitement subséquent à cette température,
après quoi la couche est refroidie jusqu'à la température ambiante.

2. Procédé selon la revendication 1, caractérisé en ce que les composés organométalliques sont décomposés approximativement en moins d'une heure à une température comprise entre 300 et 600°C.

3. Procédé selon la revendication 1 ou 2, caractérisé en ce que la couche est soumis à un traitement subséquent à une température de 650°C pendant approximativement une heure.
